# EUROPEAN PATENT SPECIFICATION

(11) **EP 0 321 212 B1**
(45) Date of publication and mention of the grant of the patent: **02.06.1993**
(21) Application number: 88311829.1
(22) Date of filing: 14.12.1988
(51) Int. Cl.: H01R 13/115, H05K 7/10

(54) **Socket for pin grid array**
Steckerbuchse für Stiftegitter
Alvéole pour grille de broches

(30) Priority: 15.12.1987 US 132307
(43) Date of publication of application: 21.06.1989
(73) Proprietor: THE WHITAKER CORPORATION, Wilmington, Delaware 19808 (US)
(72) Inventor: Marks, Richard Lee, Mechanicsburg Pennsylvania 17055 (US); Thrush, Roger Lee, Clemmons North Carolina 27012 (US)
(74) Representative: Warren, Keith Stanley

(56) References cited:
- FR-A- 2 529 023
- FR-A- 2 579 834
- GB-A- 1 087 299
- NL-A- 6 912 744

## Description

The subject invention relates to sockets for soldering to printed circuit boards which can accept a pin grid array (PGA) having a plurality of pins.

U.S. Patent 4,498,725; U.S. Patent 4,648,669; and U.S. Patent 4,679,318 relate generally to sockets for pin grid arrays.

Both U.S. Patent 4,648,668 and U.S. Patent 4,498,723 relate to a pin grid array socket which is generally known as a zero insertion force socket. Each of those patents receive a pin grid array and a mechanism is included with the socket which moves the pin grid array into registration with the socket contacts and into electrical engagement therewith.

U.S. Patent 4,679,318 relates to a socket for a pin grid array which is not zero insertion force and the terminals include opposed contact portions which extend upwardly from a strap or bight portion for receiving a pin downwardly therethrough. A shortcoming of this terminal is that the forces to overcome the spreading of the contact arms to accept the pin, referred to as insertion force, are great due to the dynamics resultantly created by the contact configuration.

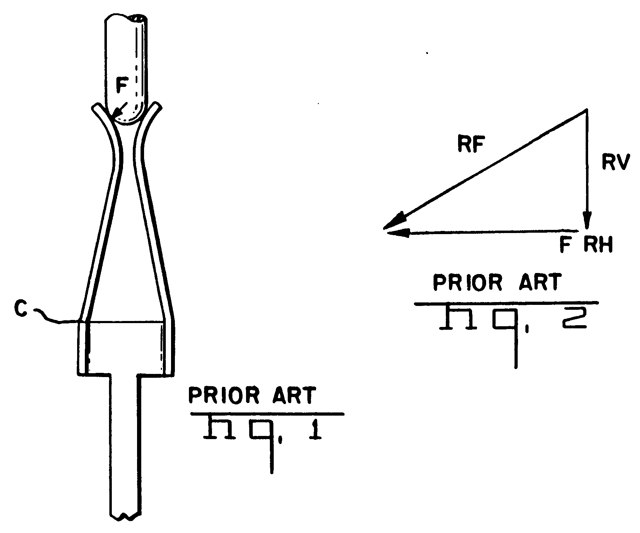

With reference to Figure 1, the terminal of U.S. Patent 4,679,318 is depicted where, the registration of the terminal with respect to the pin is shown, and the pin is shown poised for receipt within the terminal and in initial contact with the contact arms. At the moment of contact between the pin and the contact arms, a resultant force F is imposed on each of the contact arms normal to the point of contact.

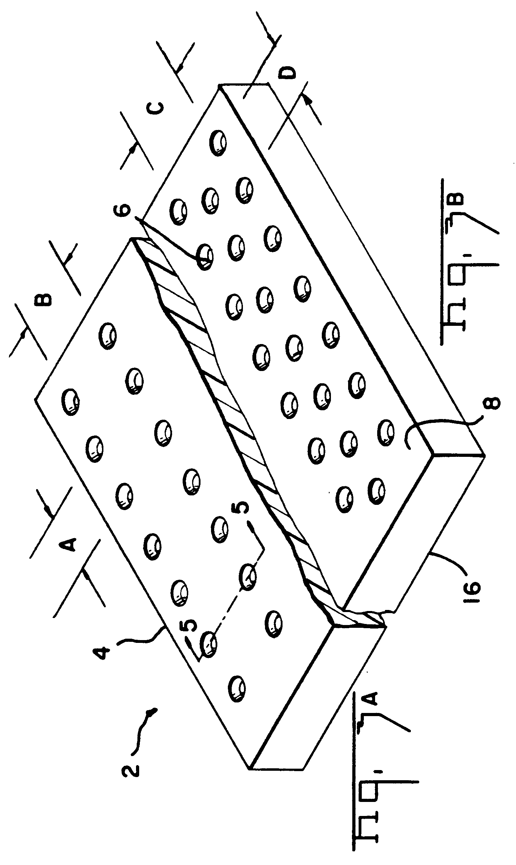

Figure 2 shows that the force imposed on the contact arms includes two components, a vertical component F_{V} and a horizontal component F_{H}. Given that the contact arms will rotate about the interconnection between the contact arms and the strap at a point such as C, the vertical component F_{V} will impose a clockwise moment on the contact arms, with respect to point C, and will attempt to pinch the contact arms closed. Admittedly, the horizontal component F_{H} is larger than the vertical F_{V} and the resultant moment will be counterclockwise about point C, and will open the contact arms and accept the pin. However, the vertical component of the force is doing negative work by attempting to close the contact arms, therefore, the overall force must be increased to achieve a horizontal force large enough to open the contact arms. As the number of pins on the PGAs increases, so will the total insertion force required to insert the PGAs within their associated sockets, which could resultantly damage the PGAs.

Furthermore, the terminal shown in U.S. Patent 4,679,318 appears to use the strap portion and the side walls for retention of the terminal within the respective apertures, which disallows the expansion of the strap portion.

Furthermore, the terminals in U.S. Patent 4,679,318 appear to be box-shaped and are not capable for use in a high density array.

The state of the art in pin grid arrays has a recent requirement for higher density spacing requirements for the pins on the array. It is believed that no such socket terminal is commercially available which can accommodate these increases in pin density.

Therefore, it is an object of the instant invention to design a terminal for a pin grid array socket which is capable for use in such high density arrays.

It is a further object of the invention to minimize the insertion force of the pin grid array.

The present invention consists in an electrical socket for interconnecting a pin grid array to a printed circuit board, the pin grid array including an insulative carrier member having a leadless chip receiving cavity in either of an upper or lower face and an array of pins attached to the upper face, the socket comprising an insulating housing having an upper carrier receiving face and a lower printed circuit board receiving face, the housing having a plurality of apertures extending between the two housing faces; and a plurality of electrical terminals disposed within the apertures, each including a longitudinal strap portion which includes an integral pin receiving portion for electrical interconnection with one of the pins of the pin grid array, and an elongate tail portion extending beyond the printed circuit board receiving face for electrical connection with a printed circuit board, wherein the pin receiving portion of each terminal includes a band portion disposed proximate to the upper carrier receiving face and having resilient contact arms extending therefrom with a free end extending downwardly into the aperture, the contact arms converging generally inwardly towards the printed circuit board receiving face, characterized in that the strap portion of each terminal is inwardly directed to form a further resilient contact member.

A point of contact on the resilient contact member of strap portion is preferably axially offset, from points of contact on radiused contact portions of the contact arms.

FR-A-2 579 834 discloses a socket according to the preamble of claim 1 but in which the pin grid array carrier does not have a chip receiving cavity.

Embodiments of the present invention will now be described by way of example with reference to the accompanying drawings in which:
Figure 1 shows the disposition of a terminal and pin of a prior art socket.
Figure 2 is a diagrammatic view of the resultant force of the pin on the terminal of the prior art.
Figure 3A shows a first embodiment of the socket of the instant invention.
Figure 3B shows a second embodiment of the socket of the instant invention.
Figure 4 shows a conventional pin grid array.
Figure 5 is a cross-sectional view through lines 5-5 of Figure 3A.
Figure 6 is a perspective view of the terminal used in the instant invention.
Figure 7 is a top plan view of the stamped blank used in the instant invention.

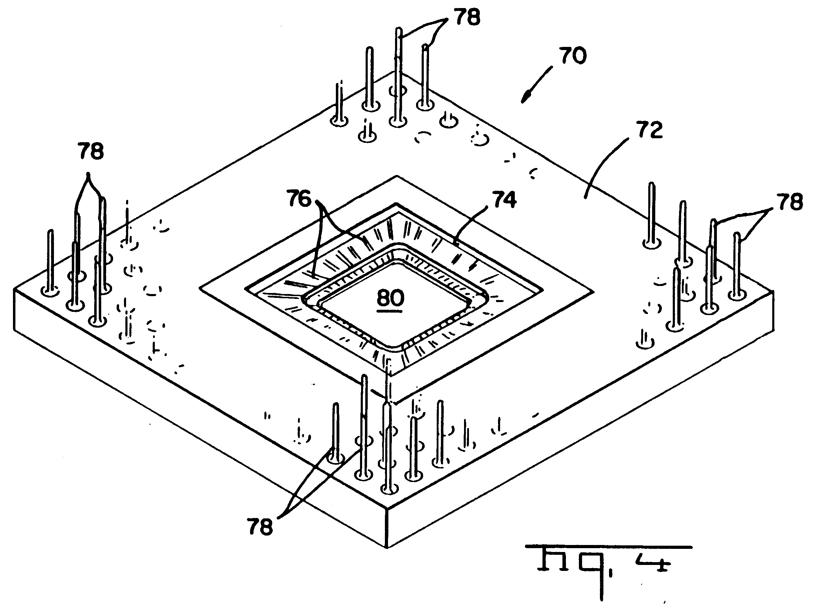

The state of the art in pin grid arrays has recently developed a requirement for higher density arrays, which results in the two patterns of sockets shown in Figures 3A and 3B. The first pattern is a square pattern where the distances between the pins is 0.127 cm (0.050 inch). The second pattern is known as an "interstitial" pattern where, four pins are provided on a square pattern spaced on 0.254 cm (0.100 inch) centers and a fifth pin is included centered intermediate every four pins. It is believed that no such socket is commercially available which would accommodate either of the two configurations of aforementioned pin grid arrays.

According to the embodiments to be described herein a socket, and the terminals therefor, are capable of accommodating the pin grid arrays which are configured as described above.

Referring first to Figures 3A and 3B, the socket 2 of the first and second embodiments of the invention includes an insulative housing 4 with a plurality of apertures 6 extending through the housing 4. The housing 4 includes an upper face, such as 8, and a lower printed circuit board receiving face 16. As discussed above, two designs of sockets are included, the first shown in Figure 3A where the distances "a" and "b" are 0.127 cm (0.050 inches) and the second embodiment shown in Figure 3B where the distances "c" and "d" are 0.254 cm (0.100 inches) with a fifth aperture 6 intermediate every four apertures, the second embodiment being called the interstitial configuration.

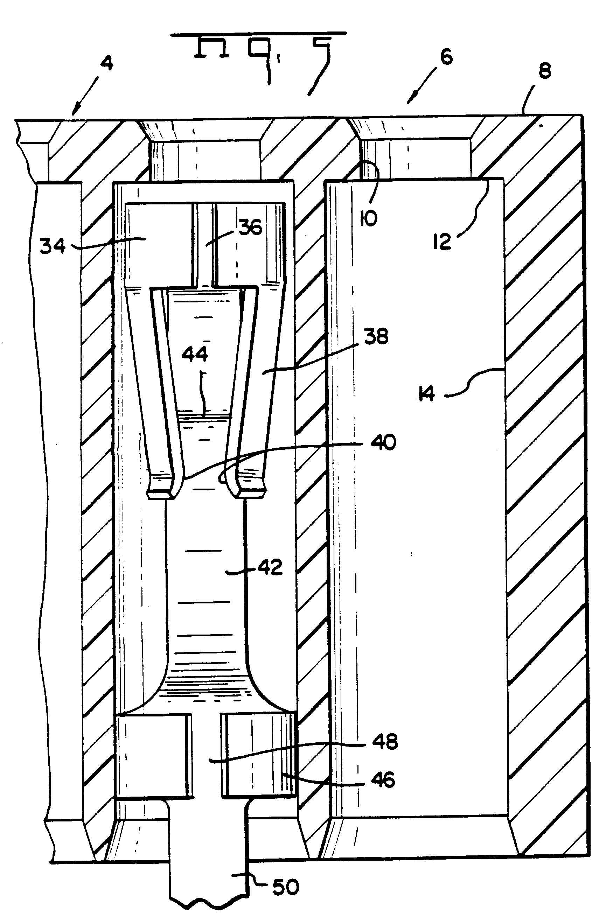

In either event, the socket will be profiled for receiving a pin grid array, such as that shown in Figure 4 as 70, where the pin grid array 70 includes a carrier receiving body, such as 72, having a plurality of pins configured in a dense array as mentioned above. The pin grid array 70 further comprises a chip receiving pocket, shown as 74, which receives the leadless chip 80 in a protective manner and serves as a nest In which the chip 80 can be brazed, epoxied, or otherwise attached. The plurality of traces, such as 76, are included on the insulative carrier member 72 and are defined in a pattern extending downwardly into the chip receiving pocket for electrical interconnection with the leadless chip. The traces 76 extend outwardly from the chip receiving pocket 74 and are electrically interconnected to respective pins 78 of the chip receiving carrier.

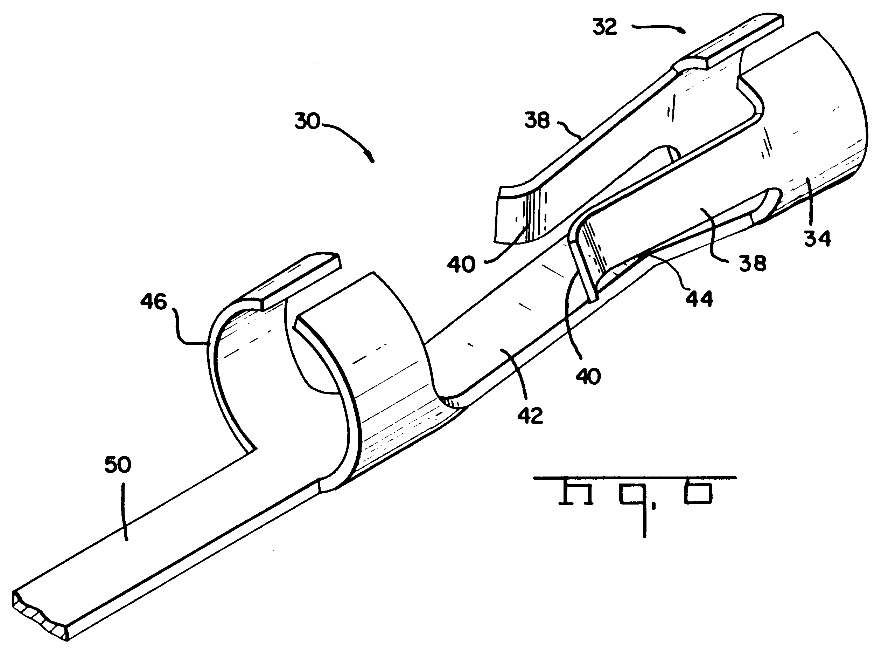

With reference now to Figure 5 which is a cross-sectional view through lines 5-5 of Figure 3A, the insulative housing 4 generally includes an upper carrier receiving face 8 and a lower printed circuit board receiving face 16 with a plurality of pin receiving apertures 6 extending between the two faces. Adjacent the carrier receiving face is a pin receiving diameter 10 which communicates with an inner diameter 14 of the aperture 6. The interface between the pin receiving diameter 10 and the inner diameter 14 defines a downwardly facing shoulder 12.

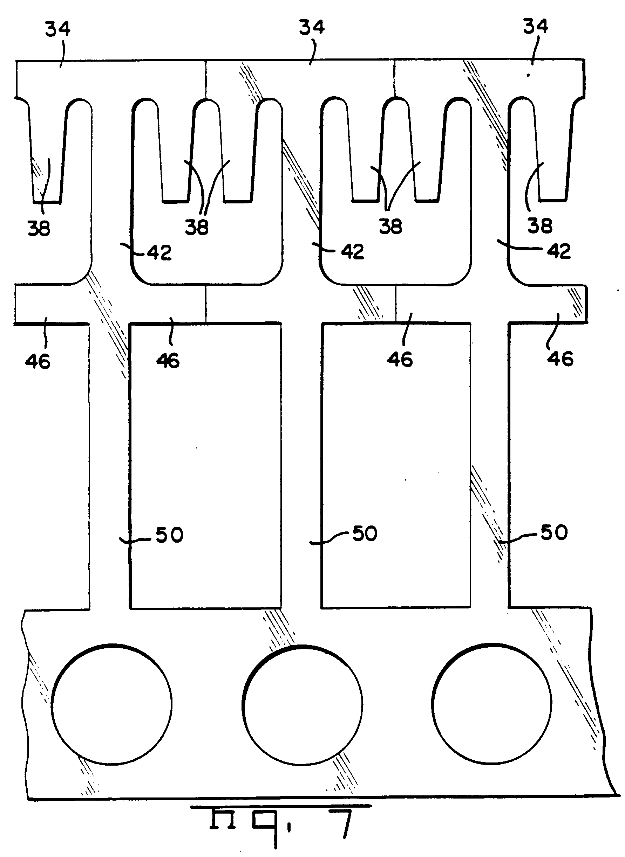

With reference to Figures 5 and 6, a plurality of terminals are inserted within the insulative housing 4 within the apertures 6 and each of the terminals generally includes a pin receiving portion 32, a retaining band 46, and a printed circuit board leg, such as 50.

The pin receiving portion 32 includes a circular band, such as 34, and further includes contact arms, such as 38, extending from the band. The terminals are stamped and formed from a flat blank, as shown in Figure 7. Thus, when the blank is rolled to form the circular band 34, a seam 36 is defined. Each of the contact arms 38 is inwardly directed towards the center of the circular band portion 34. The contact arms 38 are also formed at their ends with radiused portions 40 which form contact points. As shown in Figure 6, a strap portion 42 extends from the pin receiving portion and the strap portion is inwardly deflected to define a further contact point. A second circular band portion 46 is also included as a retention means for the terminal within the aperture 6 and is also stamped from a flat blank and then formed into a circular shape such as that shown in Figure 5. The band portion includes a seam, such as 48.

In an effort to place the terminals in the configuration shown in Figure 1 where the spacing between the terminals is 0.127 cm (0.050 inches) on a side, the terminals must per se be less than 0.127 cm (0.050 inches) on the diameter. For this reason, two opposed contact arms cannot be utilized as the width of the arms enlarges the terminal to a profile which cannot fit on the 0.127 cm (0.050 inch) by 0.127 cm (0.050 inch) grid. Rather, three contact arms are utilized where each of the contact arms is approximately 120₋ apart. However, this makes each of the contact arms 38 so small that the stress at the juncture of the contact arms and the circular band portion 34 is high enough to plastically deform the contact arms, if the arms are not post heat treated. For this reason, the cylindrical band portion is not fixedly mounted in the housing and used as a retention feature as in other prior art sockets. Rather, the outer diameter of the cylindrical band portion 34 is smaller than the inner diameter 14 of the aperture 6, thus allowing radial expansion of the cylindrical band portion 34. The radial expansion of the cylindrical band portion 34 relieves much of the stress which is created in the contact arms 38 by the insertion of the pins. Furthermore, by having the outer diameter of the circular band portion 34 smaller than the inner diameter 14 of the aperture 6, the pin receiving portion of the terminal can move towards and away from the inner diameter 14 of the aperture 6 accounting for any misalignment of the pins into the pin receiving area.

Due to the increase in density of the array of pins, the total insertion force must be kept to a minimum. For this reason, the contact arms 38 extend downwardly from the cylindrical band portion 34 and are projected towards the printed circuit board receiving face 16 rather than extending upwardly towards the upper face 8 as in previous socket designs. It should be understood from the discussion relative to Figures 1 and 2 above that a resultant force will occur on the contact arms due to the insertion of the pin and that the resultant force will be normal to the plane on the contact arm. However, since the arms are extending downwardly, the vertical and horizontal components of the force on the contact arms 38 will both create a moment which open the contact arm, thereby reducing insertion force.

To further reduce the insertion force, the point of contact between the pins and the contact arms is staggered. As shown in Figure 6, the point of contact 40 for the contact arms 38 is lower than the point of contact 44 for the strap portion 42. As the points of contact are axially offset, the force required to deflect those contact portions occurs in a stepped fashion such that the force required to open all three contact points does not occur simultaneously causing an additive force.

As the outer diameter of the cylindrical band portion 34 is smaller than the inner diameter 14 of the aperture 6, retention means independent of the pin receiving portion must be provided on the terminals. As shown in Figures 5 and 6, each of the terminals 30 further comprises a second cylindrical band portion 46 which has an outer diameter which is larger than the inner diameter 14 of the aperture 6. Thus, the circular band portion 46 becomes a circular spring which will store energy and attempt to radially expand, thereby retaining the terminals 30 within their associated apertures 6.

## Claims

1. An electrical socket (2) for interconnecting a pin grid array (70) to a printed circuit board, the pin grid array (70) including an insulative carrier member (72) having a leadless chip receiving cavity in either of an upper or lower face and an array of pins (78) attached to the upper face, the socket (2) comprising an insulating housing (4) having an upper carrier receiving face (8) and a lower printed circuit board receiving face (16), the housing (4) having a plurality of apertures (6) extending between the two housing faces (8,16); and a plurality of electrical terminals (30) disposed within the apertures (6), each including a longitudinal strap portion (42) which includes an integral pin receiving portion (32) for electrical interconnection with one of the pins (78) of the pin grid array (70), and an elongate tail portion (50) extending beyond the printed circuit board receiving face (16) for electrical connection with a printed circuit board, wherein the pin receiving portion (32) of each terminal (30) includes a band portion (34) disposed proximate to the upper carrier receiving face (8) and having resilient contact arms (38) extending therefrom with a free end extending downwardly into the aperture (6), the contact arms (38) converging generally inwardly towards the printed circuit board receiving face, characterized in that the strap portion (42) of each terminal (30) is inwardly directed to form a further resilient contact member (44).

2. A socket as claimed in claim 1, characterized in that a point of contact on the further resilient contact member (44) of the strap portion is axially offset from points of contact on radiused contact portions (40) of the contact arms (38).

3. A socket as claimed in claim 1 or 2, characterized in that each terminal (30) includes retention means comprising a second band portion (46) which is annular and defines a seam (48) and which is disposed between the pin receiving portion (32) and the tail portion (50), the second band portion (46) profiled for interferingly fitting within a respective one of the apertures (6).

4. A socket as claimed in claim 3, characterized in that the band portions (34) have outer profiles which are less than inner profiles of the apertures (6) thereby allowing movement of centers of the band portions (34) relative to the apertures (6).

5. A socket as claimed in claim 1, characterized in that each band portion (34) has a seam (36), the seam (36) and the strap portion (42) being substantially diametrically opposed to each other, the contact arms (38) of each pin receiving portion (32) extending downwardly from the band portion (34) with each of the contact arms (38) on opposite sides of the seam (36), but not being diametrically opposed to each other, the strap portion (42) of each terminal (30) being inwardly directed at a position adjacent to the pin receiving portion (32) of the terminal (30) to provide said further resilient contact member (44) in cooperation with the contact arms (38).

6. A socket (2) as claimed in claim 5, characterized in that each of the contact arms (38) is radially positioned 120 degrees from the strap portion (42) and on opposite sides of the strap portion (42).

## Patentansprüche

1. Elektrische Buchse (2) zum Verbinden eines Stiftegitters (70) mit einer gedruckten Leiterplatte, wobei das Stiftegitter (70) ein isolierendes Trägerglied (72) aufweist, das einen leiterlosen Chipaufnahme-Hohlraum in entweder einer oberen oder einer unteren Fläche und eine Anordnung von Stiften (78) aufweist, die an der oberen Fläche befestigt sind, wobei die Buchse (2) ein isolierendes Gehäuse (4) aufweist, das eine obere Trägeraufnahmefläche (8) und eine untere Aufnahmefläche (16) für die gedruckte Leiterplatte hat, wobei das Gehäuse (4) eine Vielzahl von Öffnungen (6) hat, die sich zwischen den beiden Gehäuseflächen (8,16) erstrecken, und wobei innerhalb der Öffnungen (6) eine Vielzahl elektrischer Anschlüsse (30) angeordnet ist, die jeweils einen längsverlaufenden Bügelabschnitt (42) aufweisen, der einen integralen Stiftaufnahmeabschnitt (32) zur elektrischen Verbindung mit einem der Stifte (78) des Stiftegitters (70) aufweist, wobei ein länglicher Schwanzabschnitt (50) vorgesehen ist, der sich über die Aufnahmefläche (16) für die gedruckte Leiterplatte hinaus zur elektrischen Verbindung mit einer gedruckten Leiterplatte erstreckt, wobei der Stiftaufnahmeabschnitt (32) jedes Anschlusses (30) einen Band-abschmitt (34) aufweist, der benachbart zu der oberen Trägeraufnahmefläche (8) angeordnet ist und der nachgiebige Kontaktarme (38) hat, die davon vorragen, wobei ein freies Ende sich nach unten in die Öffnung (6) erstreckt, wobei die Kontaktarme (38) allgemein nach innen auf die Aufnahmefläche für die gedruckte Leiterplatte zu konvergieren, **dadurch gekennzeichnet**, daß der Bügelabschnitt (42) jedes Anschlusses (30) nach innen gerichtet ist, um ein weiteres nachgiebiges Kontaktglied (44) zu bilden.

2. Buchse nach Anspruch 1, **dadurch gekennzeichnet,** daß ein Kontaktpunkt an dem weiteren nachgiebigen Kontaktglied (44) des Bügelabschnitts axial von den Kontaktpunkten an abgerundeten Kontaktabschnitten (40) der Kontaktarme (38) versetzt ist.

3. Buchse nach Anspruch 1 oder 2, **dadurch gekennzeichnet,** daß jeder Anschluß (30) Halterungsmittel aufweist, die einen zweiten Bandabschnitt (46) umfassen, der ringförmig ist und einen Saum (48) bildet und der zwischen dem Stiftaufnahmeabschnitt (32) und dem Schwanzabschnitt (50) angeordnet ist, wobei der zweite Bandabschnitt (46) profiliert ist, um in eine entsprechende der Öffnungen (6) mit Festsitz einzugreifen.

4. Buchse nach Anspruch 3, **dadurch gekennzeichnet,** daß die Bandabschnitte (34) äußere Profile haben, die kleiner sind als innere Profile der Öffnungen (6), wodurch eine Bewegung von Mittelteilen der Bandabschnitte (34) relativ zu den Öffnngen (6) ermöglicht ist.

5. Buchse nach Anspruch 1, **dadurch gekennzeichnet,** daß jeder Bandabschnitt (34) einen Saum (36) hat, wobei der Saum (36) und der Bügelabschnitt (42) im wesentlichen diametral einander gegenüber angeordnet sind, daß die Kontaktarme (38) jedes Stiftaufnahmeabschnitts (32) sich nach unten von dem Bandabschnitt (34) mit jeweils einem der Kontaktarme (38) an entgegengesetzten Seiten des Saums (36) erstrecken, sich aber nicht diametral einander gegenüberliegen, und daß der Bügelabschnitt (42) jedes Anschlusses (30) an einer Stelle benachbart zu dem Stiftaufnahmeabschnitt (32) des Anschlusses (30) nach innen gerichtet ist, um das weitere nachgiebige Kontaktglied (44) im Zusammenwirken mit den Kontaktarmen (38) zu bilden.

6. Buchse (2) nach Anspruch 5, **dadurch gekennzeichnet,** daß jeder der Kontaktarme (38) radial um 120 Grad von dem Bügelabschnitt (42) und auf entegengesetzten Seiten des Bügelabschnitts (42) angeordnet ist.

## Revendications

1. Douille électrique (2) pour interconnecter un réseau quadrillé (70) de broches à une plaquette à circuits imprimés, le réseau quadrillé (70) de broches comprenant un élément de support isolant (72) présentant une cavité de réception d'une puce sans fils dans une face supérieure ou une face inférieure et un réseau de broches (78) reliées à la face supérieure, la douille (2) comprenant un corps isolant (4) ayant une face supérieure (8) de réception de support et une face inférieure (16) de réception d'une plaquette à circuits imprimés, le corps (4) présentant plusieurs ouvertures (6) s'étendant entre les deux faces (8, 16) du corps, et plusieurs bornes électriques (30) disposées à l'intérieur des ouvertures (6), comprenant chacune une partie de bride longitudinale (42) qui est réalisée d'une seule pièce avec une partie (32) de réception de broche pour une interconnexion électrique avec une des broches (78) du réseau quadrillé (70) de broches, et une partie de queue allongée (50) s'étendant au-delà de la face (16) de réception de plaquette à circuits imprimés pour une connexion électrique avec une plaquette à circuits imprimés, la partie (32) de réception de broche de chaque borne (30) comprenant une partie de bague (34) disposée à proximité de la face supérieure (8) de réception de support et de laquelle s'étendent des lames élastiques (38) de contact ayant une extrémité libre s'étendant vers le bas et pénétrant dans l'ouverture (6), des lames (38) de contact convergeant de façon générale vers l'intérieur en direction de la face de réception de plaquette à circuits imprimés, caractérisée en ce que la partie de bride (42) de chaque douille (30) est dirigée vers l'intérieur pour former un autre élément élastique (44) de contact.

2. Douille selon la revendication 1, caractérisée en ce qu'un point de contact sur l'autre élément élastique (44) de contact de la partie de bride est décalé axialement des points de contact sur des parties arrondies (40) de contact des lames (38) de contact.

3. Douille selon la revendication 1 ou 2, caractérisée en ce que chaque borne (30) comprend des moyens de retenue comprenant une seconde partie de bague (46) qui est annulaire, qui définit un joint (48) et qui est disposée entre la partie (32) de réception de broche et la partie de queue (50), la seconde partie de bague (46) étant profilée pour s'ajuster à serrage dans l'une, respectives, des ouvertures (6).

4. Douille selon la revendication 3, caractérisée en ce que les parties de bague (34) ont des profils extérieurs qui sont plus petits que les profils intérieurs des ouvertures (6), permettant ainsi un mouvement des centres des parties de bague (34) par rapport aux ouvertures (6).

5. Douille selon la revendication 1, caractérisée en ce que chaque partie de bague (34) comporte un joint (36), le joint (36) et la partie de bride (42) étant opposés sensiblement diamétralement entre eux, les lames de contact (38) de chaque partie (32) de réception de broche s'étendant vers le bas depuis la partie de bague (34), les lames de contact (38) étant sur des côtés opposés du joint (36), mais non diamétralement opposées entre elles, la partie de bride (42) de chaque borne (30) étant dirigée vers l'intérieur en une position adjacente à la partie (32) de réception de broche de la borne (30) pour constituer ledit autre élément élastique (44) de contact en coopération avec les lames (38) de contact.

6. Douille (2) selon la revendication 5, caractérisée en ce que chacune des lames de contact (38) est positionnée radialement à 120° par rapport à la partie de bride (42) et sur des côtés opposés de la partie de bride (42).
